# EUROPEAN PATENT APPLICATION

(11) **EP 3 282 483 A1**
(43) Date of publication of application: **14.02.2018**
(21) Application number: 17737196.0
(22) Date of filing: 05.01.2017
(51) Int. Cl.: H01L 27/32

(54) **PIXEL UNIT AND METHOD FOR PREPARING THE SAME, ARRAY SUBSTRATE AND DISPLAY DEVICE**

(30) Priority: 27.05.2016 CN 201610364630
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: DONG, Xiangdan, Beijing 100176 (CN); LI, Kun, Beijing 100176 (CN); DAI, Lei, Beijing 100176 (CN)
(74) Representative: Awapatent AB
(86) International application number: PCT/CN2017/070258
(87) International publication number: WO 2017/202035

(57) **Abstract**

The present invention provides a pixel unit. The pixel unit includes a pixel definition layer, a pixel electrode, a light emitting layer and a common electrode. The pixel electrode comprises a bottom surface and a side surface. The side surface extends to a top of a side wall of the first through hole on the side wall of the first through hole. The light emitting layer is formed on the pixel electrode and covers over the pixel definition layer. The common electrode is formed on the light emitting layer and covers over the light emitting layer and extends on a top surface of the pixel definition layer. The present invention also provides a method of manufacturing a pixel unit and a display. The pixel unit according to the present invention greatly reduces scattering of a light from the light emitting layer to the surroundings to greatly alleviate color mixing phenomenon occurred between the pixel units so that the color mixing problem brought by scatting of the light is effectively solved, increases luminous area of the pixel unit to enhance overall luminance, cuts down the mask cost to significantly reduce the cost of the whole process, improves productivity and enhances the luminous effect.

## Description

### CROSS-REFERENCE TO RELATED APPLICATION

The present application claims the benefit of Chinese Patent Application No. 201610364630.6 and filed with SIPO on May 27, 2016, the entire disclosure of which is incorporated herein by reference.

### BACKGROUND

### 1. Technical Field

The present invention generally relates to the field of display technology, and particularly to a pixel unit used in an organic light emitting diode display apparatus, a method of manufacturing the same, an array substrate and a display apparatus.

### 2. Description of the Related Art

Organic light emitting diode display apparatus (OLED) is a novel light emitting technology, which emits a light by utilizing radiation of organic composition after being excited. There are two driving modes, active driving and passive driving. In an active driving, thin film transistors (TFT) are used as driving units, and pixels units are driven by respective driving units, to form a TFT driving array. An OLED which is driven by low-temperature polycrystalline silicon thin film transistors (LTPS-TFT) possesses these advantages of faster in electron transfer rate, smaller in area of thin film circuit and higher in resolution, as well as simple structure and high stability.

### SUMMARY

At least one object of the present invention is to provide a pixel unit which can avoid occurrence of color mixing phenomenon and of which a manufacturing method is simple in the process, and low in the cost, and has no influence on the luminous effect.

A further object of the present invention is to provide a method of manufacturing a pixel unit. The pixel unit can avoid occurrence of color mixing phenomenon and the method is simple in the process, and low in the cost, and has no influence on the luminous effect.

Another object of the present invention is to provide an array substrate in which the pixel unit can avoid occurrence of color mixing phenomenon and of which a manufacturing method is simple in the process, and low in the cost, and has no influence on the luminous effect.

Yet another object of the present invention is to provide a display apparatus in which the pixel unit can avoid occurrence of color mixing phenomenon and of which a manufacturing method is simple in the process, and low in the cost, and has no influence on the luminous effect.

According to one aspect of the present invention, there is provided a pixel unit, comprising: a pixel definition layer, a pixel electrode, a light emitting layer and a common electrode; wherein, the pixel definition layer has a firs through hole, within which the pixel electrode, the light emitting layer and the common electrode are laminated; the pixel electrode comprises a bottom surface portion and a side surface portion, the side surface portion extending to a top of a side wall of the first through hole on the side wall of the first through hole; the light emitting layer is formed on the pixel electrode and covers over the pixel electrode; and the common electrode is formed on the light emitting layer, covers over the light emitting layer and extends on a top surface of the pixel definition layer.

In some embodiments, the side wall of the first through hole in the pixel definition layer is formed as a flat face, an outwardly cambered face, or an inwardly cambered face or in a step shape.

In some embodiments, the pixel electrode extends to the top surface of the pixel definition layer, an end of the pixel electrode is on the top surface of the pixel definition layer, and, both an end of the light emitting layer and an end of the common electrode have a step shape.

In some embodiments, the pixel unit further comprises: a protective layer formed on the pixel definition layer and covering over an end of the pixel electrode, wherein the light emitting layer covers over the protective layer.

In some embodiments, the pixel unit further comprises: a planarization layer having a second through hole at a location corresponding to an output terminal of a driver thin film transistor, wherein the pixel definition layer is formed on the planarization layer, and the first through hole is located directly above the second through hole and is communicated with the second through hole.

According to another aspect of the present invention, there is provided an array substrate comprising: any of the abovementioned pixel units.

According to yet another aspect of the present invention, there is provided a display apparatus comprising: the abovementioned array substrate.

According to still another aspect of the present invention, there is provided a method of manufacturing a pixel unit, and, the method is used for manufacturing the pixel unit of claim 1 and comprises: forming a pixel definition layer and forming a first through hole in the pixel definition layer; forming a pixel electrode within the first through hole of the pixel definition layer, the pixel electrode having a bottom surface and a side surface, and the side surface extending to a top of a side wall of the first through hole on the side wall of the first through hole; forming a light emitting layer that covers over the pixel electrode; and forming a common electrode that covers over the light emitting layer and extends on a top surface of the pixel definition layer.

In some embodiments, the forming the pixel definition layer and the forming the first through hole in the pixel definition layer, comprises: depositing two layers of organic material in sequence, and forming, by one patterning process, a second through hole in the planarization layer and the first through hole in the pixel definition layer

In some embodiments, after the forming the pixel electrode within the first through hole of the pixel definition layer and before the forming the light emitting layer that covers over the pixel electrode, the method further comprises: depositing an organic material on the pixel definition layer, and, forming, by one patterning process, a spacer layer and a protective layer that covers over an end of the pixel electrode; and the forming the light emitting layer that covers over the pixel electrode further comprises: forming the light emitting layer on the pixel electrode such that the light emitting layer covers over the pixel electrode and the protective layer.

### BRIEF DESCRIPTION OF THE DRAWINGS

Fig. 1 is a structural schematic view of a pixel unit in a common low-temperature polycrystalline silicon thin film transistor organic light emitting diode (LTPS-TFT OLED) display apparatus;
Fig. 2 is a structural schematic view of a pixel unit according to a first embodiment of the present invention;
Fig. 3 is a structural schematic view of a pixel unit according to a second embodiment of the present invention;
Fig. 4 is a structural schematic view of a pixel unit according to a third embodiment of the present invention;
Fig. 5 is a structural schematic view of a pixel unit according to a fourth embodiment of the present invention;
Fig. 6 is a structural schematic view of a pixel unit according to a fifth embodiment of the present invention; and
Fig. 7 is a flow diagram of a method of manufacturing a pixel unit according to an eighth embodiment of the present invention.

### DETAILED DESCRIPTION OF THE EMBODIMENTS

In order to provide a more clear understanding of objects, technique solutions and advantages of embodiments of the present invention, the embodiments of the present invention will be further described hereinafter in detail and completely with reference to the attached drawings.

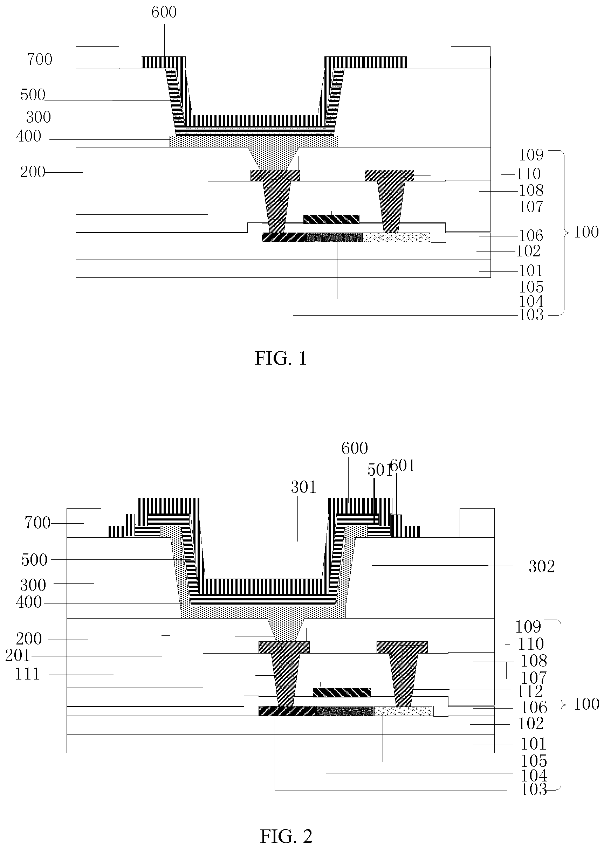

A pixel unit used in a common low-temperature polycrystalline silicon thin film transistor organic light emitting diode (LTPS-TFT OLED) display apparatus is shown in Fig. 1. The pixel unit generally includes a low-temperature polycrystalline silicon thin film transistor served as a thin film transistor 100 for driving, a planarization layer 200, a pixel definition layer 300, a pixel electrode 400, a light emitting layer 500 and a common electrode 600, and so on. Both side surfaces of the light emitting layer 500 are contacted directly with the pixel definition layer 300. A light emitted by the light emitting layer 500 scatters to the surroundings after passing through the pixel definition layer 300 and makes a color mixing with the lights scattered from other pixel units around this pixel unit, to seriously affect the display effect. Moreover, only a bottom surface of the light emitting layer 500 gets in contact with the pixel electrode 400, accordingly, the luminous area is limited so that the overall luminance is adversely affected. In addition, in a technical process of manufacturing the pixel unit as shown in Fig. 1, generally, a polycrystalline silicon (Poly), a gate insulation layer (Gate 1), a gate (Gate 2), an interlayer deposition layer (ILD), a source and a drain (SD), a planarization layer (PLN), a pixel electrode (Anode), a pixel definition layer (PDL), a spacer layer (PS), a light emitting layer evaporation (EL) and a common electrode (Vcom) are manufactured in sequence. In this process, generally, two process steps are adopted successively to manufacture a through hole in the planarization layer 200 and a through hole in the pixel definition layer 300. As a result, two masks are required, which is relatively complicated in process and relatively high in the cost. Moreover, in this process, the manner in which the pixel electrode 400 is firstly formed and then the pixel definition layer 300 is formed causes the pixel electrode 400 to be polluted by residual material for pixel electrode after the pixel definition layer 300 is formed, which adversely affects the luminous effect. Therefore, it is an urgent need in the art to provide a pixel unit which can avoid occurrence of the color mixing phenomenon and a method of manufacturing the pixel electrode which is simple in the process, and low in the cost, and has no influence on the luminous effect.

Referring to Fig. 2, Fig. 2 shows a structural schematic view of a pixel unit according to a first embodiment of the present invention. The pixel unit is formed on a driver thin film transistor and includes: a planarization layer (PLN layer) 200, a pixel definition layer (PDL layer) 300, a pixel electrode 400, a light emitting layer 500 and a common electrode 600.

In this embodiment, the driver thin film transistor may be a low-temperature polycrystalline silicon thin film transistor which includes a substrate 101, a buffer layer 102 formed on the substrate 101, an output electrode 103, a channel 104 and an input electrode 105 formed on the buffer layer 102, a gate insulation layer 106 formed on the buffer layer 102 as well as the output electrode 103, the channel 104 and the input electrode 105, a control terminal 107 formed on the gate insulation layer 106, and, an interlayer deposition layer 108 (ILD layer) formed on the control terminal 107 and the gate insulation layer 106. A third through hole 111 and a fourth through hole 112 running through the interlayer deposition layer 108 and the gate insulation layer 106 are formed directly above the output electrode 103 and the input electrode 105, respectively. An output terminal 109 has one end connected to the output electrode 103 and led out through the third through hole 111, and the other end exposed on the interlayer deposition layer 108, and, the input terminal 110 has one end connected to the input electrode 105 and led out through the fourth through hole 112, and the other end exposed on the interlayer deposition layer 108.

For the driver thin film transistor according to the present embodiment, if an N-type thin film transistor is adopted, the control terminal 107 is embodied as a gate of the driver thin film transistor, the input electrode 105 is embodied as a drain, the input terminal 110 is embodied as a drain metal, the output electrode 103 is embodied as a source and the output terminal 109 is embodied as a source metal. If a P-type thin film transistor is adopted, the control terminal 107 is embodied as a gate of the driver thin film transistor, the input electrode 105 is embodied as a source, the input terminal 110 is embodied as a source metal, the output electrode 103 is embodied as a drain and the output terminal 109 is embodied as a drain metal.

The planarization layer 200 is formed on the interlayer deposition layer 108, as well as on the output terminal 109 and the input terminal 110, of the driver thin film transistor, and has a second through hole 201 directly above the output terminal 109. The pixel definition layer 300 is formed on the planarization layer 200, and has a first through hole 301 directly above the second through hole 201. The first through hole 301 has a greater size than the second through hole 201, and is communicated with the second through hole 201.

A pixel electrode 400, a light emitting layer 500 and a common electrode 600 are formed in sequence on the pixel definition layer 300. The pixel electrode 400 comprises a bottom surface portion and a side surface portion. The bottom surface portion overspreads the bottom of the first through hole 301 and is connected with the output terminal 109 through the second through hole 201, and the side surface portion extends to a top of a side wall 302 of the first through hole 301 on the side wall 302 of the first through hole 301. The light emitting layer 500 is formed on the pixel electrode 400 and covers over the pixel electrode layer 400. The common electrode 600 is formed on the light emitting layer 500 and covers over the light emitting layer 500 and extends on a top surface of the pixel definition layer 300. In addition, a spacer layer 700 is formed on the pixel definition layer 300. In the embodiments of the present invention, the pixel electrode 400 comprises a reflective electrode formed of indium tin oxide / silver / indium tin oxide (ITO/Ag/ITO) material, or of lightproof conductive material. In the pixel unit according to the embodiments of the present invention, the pixel electrode 400 is provided between the pixel definition layer 300 and the light emitting layer 500, and a light emitted by the light emitting layer 500 are partially reflected by the reflective electrode formed of indium tin oxide / silver / indium tin oxide (ITO/Ag/ITO) material, or are blocked by the lightproof conductive material, so that scattering of a light from the light emitting layer 500 to the surroundings is greatly reduced, thereby greatly alleviating color mixing phenomenon occurred between the pixel units, to effectively solve the color mixing problem brought by scatting of the light. The pixel electrode 400 includes the side surface portion, which enables area of the pixel electrode 400 to be increased, so that contact area between the pixel electrode 400 and the light emitting layer 500 is increased, and accordingly luminous area of the pixel unit is increased without changing aperture ratio of the pixel unit, thereby enhancing overall luminance.

In an embodiment of the present invention, the substrate 101 includes a glass material, the buffer layer 102 includes silicon nitride (SiNₓ) or silicon dioxide (SiO₂) or aluminum (Al) or aluminum oxide (AL₂O₃) material, the output electrode 103, the channel 104 and the input electrode 105 are polycrystalline silicon (P-Si) material, the gate insulation layer 106 includes silicon dioxide (SiO₂) or bilayer material consisted of silicon dioxide (SiO₂)/silicon nitride (SiNₓ) or TEOS material; the control terminal 107 includes molybdenum niobium material, the output terminal 109 and the input terminal 110 includes Ti-Al-Ti material, the interlayer deposition layer 108 includes silicon nitride (SiNₓ) or silicon dioxide (SiO₂) material, the planarization layer 200 includes an organic film material, the pixel definition layer 300 includes polyimide (PI) material, the light emitting layer 500 includes organic light emitting material such as Alq, Balq and DPVBi, etc., and, the common electrode 600 include metal alloy such as Mg-Ag.

In some embodiments, referring to Fig. 2, the pixel electrode 400 may further extend to the top surface of the pixel definition layer 300, and an end of the pixel electrode 400 is located on the top surface of the pixel definition layer 300. An end 501 of the light emitting layer has a step shape and covers over the end of the pixel electrode 400. An end 601 of the common electrode has a step shape and covers over the end 501 of the light emitting layer and extends on the top surface of the pixel definition layer 300. This further increases the areas of the pixel electrode 400 and the light emitting layer 500, so that the contact area between the pixel electrode 400 and the light emitting layer 500 is further increased, and accordingly, overall luminance of the pixel unit is further enhanced without changing aperture ratio of the pixel unit, while avoiding the color mixing problem caused by scattering of the light.

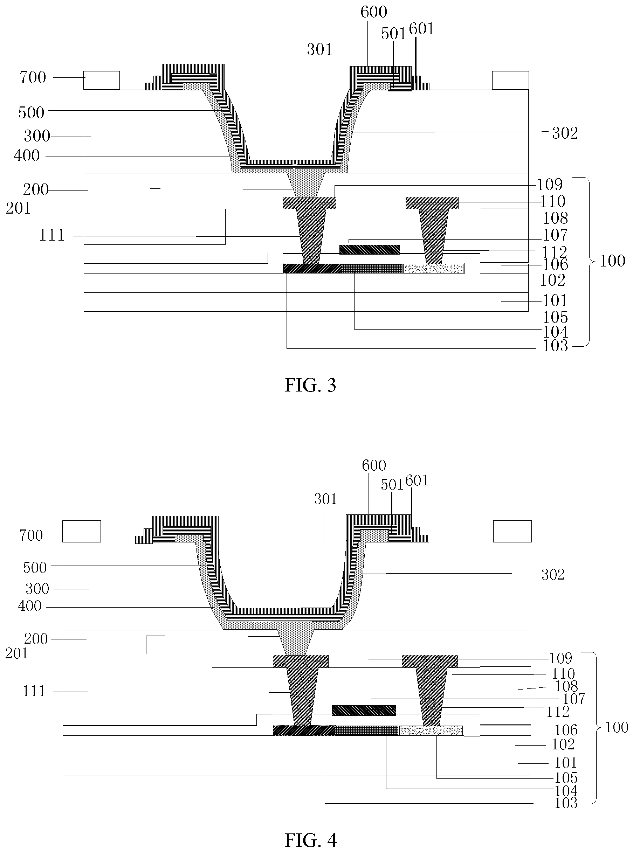

Fig. 3 shows a structural schematic view of a pixel unit according to a second embodiment of the present invention. For brief purpose, technical features of the first embodiment which can be employed in the second embodiment are incorporated herein by reference, but are omitted to avoid duplicating description. The following description only relates to these technical features of the second embodiment different from the first embodiment.

The side wall 302 of the first through hole 301 in the pixel definition layer 300 has an outwardly cambered face, and the side surface of the pixel electrode 400 extends to the top of the side wall 302 of the first through hole 301 on the outwardly cambered face of the side wall 302 of the first through hole 301. The light emitting layer 500 is formed on the pixel electrode 400 and covers over the pixel definition layer 300. The common electrode 600 is formed on the light emitting layer 500 and covers over the light emitting layer 500 and extends on the top surface of the pixel definition layer 300. The area of the side wall 302 of the first through hole 301 in the pixel unit according to the second embodiment is greater than that of the side wall 302 of the first through hole 301 in the pixel unit according to the first embodiment, which further increases the areas of the pixel electrode 400 and the light emitting layer 500, so that the contact area between the pixel electrode 400 and the light emitting layer 500 is further increased, and accordingly, overall luminance of the pixel unit is further enhanced without changing aperture ratio of the pixel unit, while avoiding the color mixing problem caused by scattering of the light.

In some embodiments, as shown in Fig. 3, the pixel electrode 400 may further extend to the top surface of the pixel definition layer 300, and an end of the pixel electrode 400 is located on the top surface of the pixel definition layer 300. An end 501 of the light emitting layer has a step shape and covers over the end of the pixel electrode 400. The end 601 of the common electrode has a step shape and covers over the end 501 of the light emitting layer and extends on the top surface of the pixel definition layer 300. This further increase the areas of the pixel electrode 400 and the light emitting layer 500, so that the contact area between the pixel electrode 400 and the light emitting layer 500 is further increased, and accordingly, overall luminance of the pixel unit is further enhanced without changing aperture ratio of the pixel unit, while avoiding the color mixing problem caused by scattering of the light.

Fig. 4 shows a structural schematic view of a pixel unit according to a third embodiment of the present invention. For brief purpose, technical features of any one of the above embodiments which can be employed in the third embodiment are incorporated herein by reference, but are omitted to avoid duplicating description. The following description only relates to these technical features of the third embodiment different from other embodiments.

The side wall 302 of the first through hole 301 in the pixel definition layer 300 has an inwardly cambered face, and the side surface of the pixel electrode 400 extends to the top of the side wall 302 of the first through hole 301 on the inwardly cambered face of the side wall 302 of the first through hole 301. The light emitting layer 500 is formed on the pixel electrode 400 and covers over the pixel definition layer 300. The common electrode 600 is formed on the light emitting layer 500 and covers over the light emitting layer 500 and extends on the top surface of the pixel definition layer 300. The area of the side wall 302 of the first through hole 301 in the pixel unit according to the third embodiment is greater than that of the side wall 302 of the first through hole 301 in the pixel unit according to the first embodiment, which further increases the areas of the pixel electrode 400 and the light emitting layer 500, so that the contact area between the pixel electrode 400 and the light emitting layer 500 is further increased, and accordingly, overall luminance of the pixel unit is further enhanced without changing aperture ratio of the pixel unit, while avoiding the color mixing problem caused by scattering of the light.

In some embodiments, as shown in Fig. 4, the pixel electrode 400 may further extend to the top surface of the pixel definition layer 300, and an end of the pixel electrode 400 is located on the top surface of the pixel definition layer 300. An end 501 of the light emitting layer has a step shape and covers over the end of the pixel electrode. The end 601 of the common electrode has a step shape and covers over the end 501 of the light emitting layer and extends on the top surface of the pixel definition layer 300. This further increase the areas of the pixel electrode 400 and the light emitting layer 500, so that the contact area between the pixel electrode 400 and the light emitting layer 500 is further increased, and accordingly, overall luminance of the pixel unit is further enhanced without changing aperture ratio of the pixel unit, while avoiding the color mixing problem caused by scattering of the light.

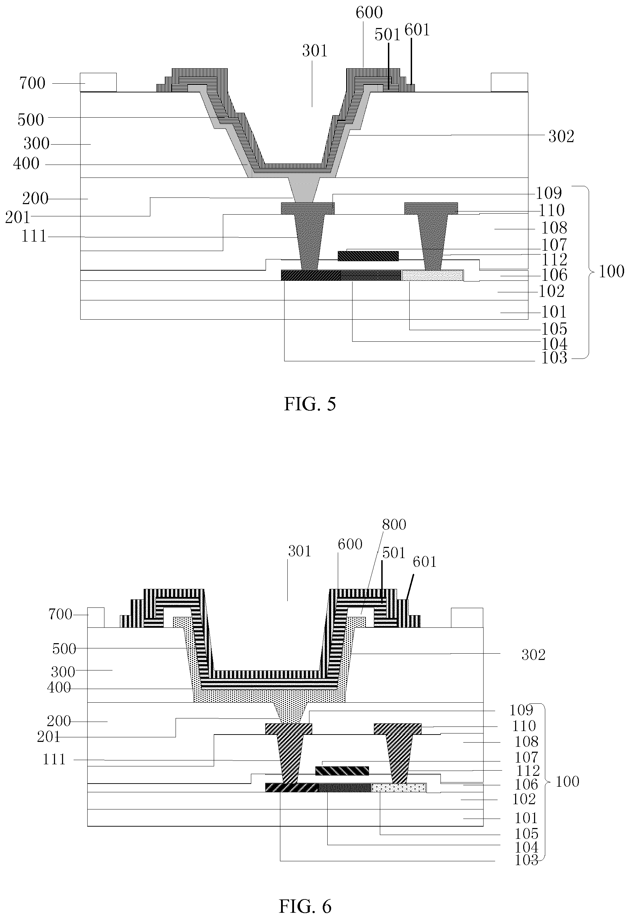

Fig. 5 shows a structural schematic view of a pixel unit according to a fourth embodiment of the present invention. For brief purpose, technical features of any one of the above embodiments which can be employed in the fourth embodiment are incorporated herein by reference, but are omitted to avoid duplicating description. The following description only relates to these technical features of the fourth embodiment different from other embodiments.

An upper half portion of the first through hole 301 in the pixel definition layer 300 is expanded outwardly to form a step, namely, the side wall 302 having a step shape is formed, and the side surface of the pixel electrode 400 extends to the top of the side wall 302 of the first through hole 301 on the step-shaped side wall 302 of the first through hole 301. The light emitting layer 500 is formed on the pixel electrode 400 and covers over the pixel definition layer 300. The common electrode 600 is formed on the light emitting layer 500 and covers over the light emitting layer 500 and extends on the top surface of the pixel definition layer 300. The area of the side wall 302 of the first through hole 301 in the pixel unit according to the fourth embodiment is greater than that of the side wall 302 of the first through hole 301 in the pixel unit according to the first embodiment, which further increases the areas of the pixel electrode 400 and the light emitting layer 500, so that the contact area between the pixel electrode 400 and the light emitting layer 500 is further increased, and accordingly, overall luminance of the pixel unit is further enhanced, while avoiding the color mixing problem caused by scattering of the light.

In some embodiments, as shown in Fig. 5, the pixel electrode 400 may further extend to the top surface of the pixel definition layer 300, and an end of the pixel electrode 400 is located on the top surface of the pixel definition layer 300. An end 501 of the light emitting layer has a step shape and covers over the end of the pixel electrode. The end 601 of the common electrode has a step shape and covers over the end 501 of the light emitting layer and extends on the top surface of the pixel definition layer 300. This further increase the areas of the pixel electrode 400 and the light emitting layer 500, so that the contact area between the pixel electrode 400 and the light emitting layer 500 is further increased, and accordingly, overall luminance of the pixel unit is further enhanced, while avoiding the color mixing problem caused by scattering of the light.

Fig. 6 shows a structural schematic view of a pixel unit according to a fifth embodiment of the present invention. For brief purpose, technical features of any one of the above embodiments which can be employed in the fifth embodiment are incorporated herein by reference, but are omitted to avoid duplicating description. The following description only relates to these technical features of the fifth embodiment different from other embodiments.

As another alternative embodiment of the present invention, the pixel unit further comprises: a protective layer 800. The protective layer 800 is formed on the pixel definition layer 300 and covers over an end of the pixel electrode 400. The light emitting layer 500 is formed on the pixel electrode and covers over the protective layer 800. The common electrode 600 is formed on the light emitting layer 500 and covers over the light emitting layer 500 and extends on the top surface of the pixel definition layer 300.

The protective layer according to the present embodiment may be applied on the pixel unit according to any one of the abovementioned first to fourth embodiments of the present invention. The description will be followed by taking the pixel unit which is shown in Fig. 1 and includes a protective layer as an example. Referring to Fig. 6, the protective layer 800 covers over an end of the pixel electrode 400, to separate the end of the pixel electrode 400 and the common electrode 600 from each other, thereby preventing occurrence of point discharging phenomenon between the pixel electrode 400 and the common electrode 600 and enhancing display stability and display effect of the pixel unit.

An array substrate is provided according to a sixth embodiment of the present invention. The array substrate comprises a gate line, a data line and the pixel unit of any one of the abovementioned embodiments. The gate line is connected to the control terminal 107 of the driver thin film transistor, and the data line is connected to the input terminal 110 of the driver thin film transistor.

A display apparatus is provided according to a seventh embodiment of the present invention. The display apparatus comprises the array substrate of the sixth embodiment and a cover plate.

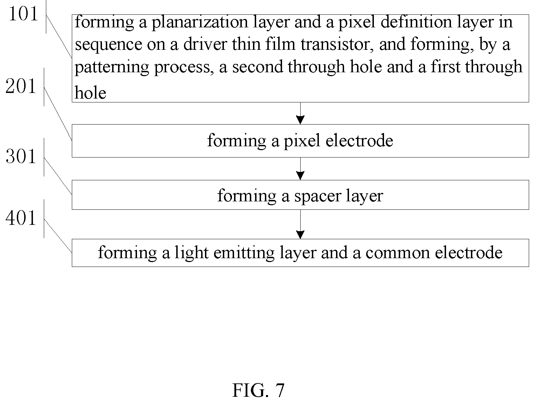

A method of manufacturing a pixel unit is provided according to an eighth embodiment of the present invention. Referring to Fig. 7, the method is used for manufacturing the pixel unit of any one of the abovementioned first to fifth embodiments. The method may specifically comprise the following steps.

A step 101 is of forming a planarization layer and a pixel definition layer in sequence on the driver thin film transistor, and forming, by a patterning process, a second through hole and a first through hole.

The mentioned patterning process may include but not be limited to Half Tone Mask process, as long as the second through hole and the first through hole are manufactured.

When the Half Tone Mask process is adopted, the step 101 specifically includes, coating an organic film material, and depositing polyimide (PI) material on the organic film material. Once a Half Tone Mask photolithographic process is adopted, one Half Tone Mask is used to form the second through hole in the planarization layer and the first through hole in the pixel definition layer at the same time. The Half Tone Mask is a multi-gray mask which is divided into a lightproof part, a semi-transparent part and a transparent part. The Half Tone Mask can be used to present three levels of exposures, namely an exposed part, a semi-exposed part and a non-exposed part, at one exposure process. In particular, in the Half Tone Mask, the transparent part is used for exposing for the second through hole and the semi-transparent part is used for exposing for the first through hole, so that the second through hole in the planarization layer and the first through hole in the pixel definition layer are formed at the same time.

In prior art, the second through hole and the first through hole are successively formed in two process steps, accordingly, two masks are required. When the Half Tone Mask process is adopted to form the second through hole and the first through hole, only one half tone mask is required, and the second through hole and the first through hole are formed in one photolithography process. This simplifies the process, shortens production time, cuts down the mask cost to significantly reduce the cost of the whole process, and improves productivity. The prior art manner in which the pixel electrode is firstly formed and then the pixel definition layer is formed causes the pixel electrode to be polluted by residual material for pixel electrode after the pixel definition layer is formed, which adversely affects the luminous effect. Whatever, the process, in which the pixel definition layer is formed firstly and then the pixel electrode is formed, provided by the present invention avoids the abovementioned problems and greatly enhances luminous effect.

A step 201 is of forming a pixel electrode.

The step 201 may specifically include: forming an ITO coating, an Ag coating and an ITO coating in sequence. After being implemented with photolithography, wet-etching, photoresist removal and degradation, a pixel electrode is formed within the first through hole of the pixel definition layer. The pixel electrode has a bottom surface portion and a side surface portion, and the side surface portion extends to a top of a side wall of the first through hole on the side wall of the first through hole.

A step 301 is of forming a spacer layer.

The step 301 may specifically include: depositing polyimide (PI) material on the pixel definition layer, and forming the spacer layer after being implemented with photolithography.

In another embodiment of the present invention, the step 301 may also specifically include: depositing polyimide (PI) material on the pixel definition layer, and forming, by one patterning process, the spacer layer and the protective layer which covers over the end of the pixel electrode.

In the step 301 according to the present embodiment, the spacer layer and the protective layer may be synchronously manufactured in one deposition and one patterning process, which has no additional process step for formation of the protective layer, thereby simplifying the process and controlling the cost.

A step 401 is of forming a light emitting layer and a common electrode.

The step 401 may specifically include:
a sub-step 4011 of depositing, by a vacuum thermal evaporation process, an organic light emitting material, and forming, by a patterning process, a light emitting layer on the pixel electrode, the light emitting layer covering over the pixel electrode.

In another embodiment of the present invention, the sub-step 4011 may also specifically include: depositing, by a vacuum thermal evaporation process, an organic light emitting material, and forming, by a patterning process, a light emitting layer on the pixel electrode, the light emitting layer covering over the pixel electrode and the protective layer.

A sub-step 4012 is of: depositing, by a vacuum thermal evaporation process, a metal alloy, and forming, by a patterning process, a common electrode on the light emitting layer, the common electrode covering over the light emitting layer and extending on the top surface of the pixel definition layer.

In some embodiments, before manufacturing the pixel unit, a step of manufacturing a driver thin film transistor, namely, a low-temperature polycrystalline silicon thin film transistors, is further included, and this step comprises the followings.

A sub-step Oil is of forming a buffer layer and an active layer in sequence on the substrate.

The sub-step 011 may specifically include:
cleaning and pre-treating a glass substrate;
forming the buffer layer on the glass substrate, then, forming the active layer made of a-Si material being implemented with hydrogen relief treatment; wherein, the buffer layer and the active layer are formed by using a plasma enhanced chemical vapor deposition (PECVD) process; and
spin-cleaning the active layer, and implementing a polysilicon crystallization by using an excimer laser annealing (ELA) process, to generate polycrystalline silicon P-Si.

A sub-step 012 is of etching the polycrystalline silicon to form an output electrode, an input electrode and a channel.

The sub-step 012 may specifically include: etching the polycrystalline silicon P-Si by a photolithography process to form the output electrode and the input electrode and the channel which have been patterned.

A sub-step 013 is of forming a gate insulation layer.

The sub-step 013 may specifically include: implementing a spin clean firstly, depositing silicon dioxide (SiO₂) or bi-layer material consisted of silicon dioxide (SiO₂)/silicon nitride (SiNₓ) by using a plasma enhanced chemical vapor deposition (PECVD) process, and forming the gate insulation layer by a patterning process.

A sub-step 014 is of forming a control terminal on the gate insulation layer.

The sub-step 014 may specifically include: implementing a spin clean firstly, and implementing film deposition, photolithography, enhanced capacitively coupled plasma (ECCP) dry etching and photoresist removal on the molybdenum niobium material, to obtain the control terminal which has been patterned.

A sub-step 015 is of forming an interlayer deposition layer and then etching a third through hole and a fourth through hole of the interlayer deposition layer and the gate insulation layer.

The sub-step 015 may specifically include: implementing a clean with hydrofluoric acid (BHF), forming silicon nitride (SiNₓ) or silicon dioxide (SiO₂) material into films and implementing hydrogenation, and then implementing photolithography, inductively coupled plasma (ICP) etching and photoresist removal, to obtain the third through hole and the fourth through hole.

A sub-step 016 is of forming an output terminal and an input terminal.

The sub-step 016 may specifically include: implementing a clean with hydrofluoric acid (BHF), forming Ti-Al-Ti material into a film, and then implementing photolithography, enhanced capacitively coupled plasma (ECCP) dry etching, photoresist removal and metal annealing, to obtain the output terminal and the input terminal.

Thus it can be seen from the above, the pixel unit used in an organic light emitting diode display apparatus and the method of manufacturing the same, the array substrate and the display apparatus according to the embodiments of the present invention have at least one of the following beneficial advantages.
(1) The side surface portion of the pixel electrode extends to the top of the first through hole on the side wall of the first through hole, which greatly reduces scattering of a light from the light emitting layer to the surroundings, so that color mixing phenomenon occurred between the pixel units are greatly alleviated, thereby effectively solving the color mixing problem brought by scatting of the light.
(2) Area of the pixel electrode is increased, so that contact area between the pixel electrode and the light emitting layer is increased, and accordingly luminous area of the pixel unit is increased without changing aperture ratio of the pixel unit, thereby enhancing overall luminance.
(3) Provision of the step-shaped ends of the light emitting layer and the common electrode further increase the luminous area, which also further enhances overall luminance.
(4) Half Tone Mask is adopted in the manufacturing method to form the second through hole and the first through hole by one photolithographic process, which simplifies the process, shortens production time, cuts down the mask cost to significantly reduce the cost of the whole process, and improves productivity.
(5) A manner in which the pixel definition layer is firstly formed and then the pixel electrode is formed avoids the pixel electrode to be polluted by residual material for pixel electrode after the pixel definition layer is formed, which improves the luminous effect.
(6) The protective layer covers over an end of the pixel electrode, to separate the end of the pixel electrode and the common electrode from each other, thereby preventing occurrence of point discharging phenomenon between the pixel electrode and the common electrode and enhancing display stability and display effect of the pixel unit.

To this, embodiments of the present invention have been described in conjunction with the drawings. In accordance with the above description, those skilled in the art may have a clear understanding of the pixel unit and the method of manufacturing the same, the array substrate and the display apparatus according to the present invention.

It should be explained that, in the drawings or the description of the present disclosure, any implementations which are not illustrated or not described belong to well-knowledge for those skilled in the art and are not described and explained in detail. In addition, the abovementioned definitions of these elements are not only limited to these specific configuration, shape or manner disclosed in the embodiments, and those skilled in the art may easily make any simple change or replacement. The followings are taken as examples.
(1) The side wall of the first through hole may also be presented in any other shape(s).
(2) These orientational terminologies such as "above", "below", "front", "rear", "left", "right" and the likes are used for easing or simplifying the orientations in the drawings, instead of limiting the protective scope of the present invention.
(3) Based on considerations in design and reliability, these abovementioned embodiments may be combined freely with one another or with other embodiments, that is, Technical features described in these embodiments may be combined freely to generate much more embodiments.

The above specific embodiments are provided to further describe and explain objects, technique solutions and advantages of the present invention. It should be understood that, the above description is merely used to illustrate specific embodiments of the present invention, but not to limit the present invention. All of changes, equivalent alternatives, modifications, made within principles and spirit of the present invention, should be included within the scope of the present invention.

## Claims

1. A pixel unit, **characterized by** comprising: a pixel definition layer, a pixel electrode, a light emitting layer and a common electrode; wherein,
the pixel definition layer has a firs through hole, within which the pixel electrode, the light emitting layer and the common electrode are laminated;
the pixel electrode comprises a bottom surface portion and a side surface portion, the side surface portion extending to a top of a side wall of the first through hole on the side wall of the first through hole;
the light emitting layer is formed on the pixel electrode and covers over the pixel electrode; and
the common electrode is formed on the light emitting layer, covers over the light emitting layer and extends on a top surface of the pixel definition layer.

2. The pixel unit of claim 1, **characterized in that**, the side wall of the first through hole in the pixel definition layer is formed as a flat face, an outwardly cambered face, or an inwardly cambered face or in a step shape.

3. The pixel unit of claim 1, **characterized in that**, the pixel electrode extends to the top surface of the pixel definition layer, an end of the pixel electrode is on the top surface of the pixel definition layer, and, both an end of the light emitting layer and an end of the common electrode have a step shape.

4. The pixel unit of claim 1, **characterized by** further comprising: a protective layer formed on the pixel definition layer and covering over an end of the pixel electrode, wherein the light emitting layer covers over the protective layer.

5. The pixel unit of claim 1, **characterized by** further comprising: a planarization layer having a second through hole at a location corresponding to an output terminal of a driver thin film transistor, wherein the pixel definition layer is formed on the planarization layer, and the first through hole is located directly above the second through hole and is communicated with the second through hole.

6. An array substrate, **characterized by** comprising: the pixel unit of any one of claims 1-5.

7. A display apparatus, **characterized by** comprising: the array substrate of claim 6.

8. A method of manufacturing a pixel unit, **characterized in that**, the method is used for manufacturing the pixel unit of claim 1, and comprises:
forming a pixel definition layer and forming a first through hole in the pixel definition layer;
forming a pixel electrode within the first through hole of the pixel definition layer, the pixel electrode having a bottom surface and a side surface, and the side surface extending to a top of a side wall of the first through hole on the side wall of the first through hole;
forming a light emitting layer that covers over the pixel electrode; and
forming a common electrode that covers over the light emitting layer and extends on a top surface of the pixel definition layer.

9. The method of claim 8, **characterized in that**, the forming the pixel definition layer and the forming the first through hole in the pixel definition layer, comprises:
depositing two layers of organic material in sequence, and forming, by one patterning process, a second through hole in the planarization layer and the first through hole in the pixel definition layer.

10. The method of claim 8, **characterized in that**, after the forming the pixel electrode within the first through hole of the pixel definition layer and before the forming the light emitting layer that covers over the pixel electrode, the method further comprises:
depositing an organic material on the pixel definition layer, and, forming, by one patterning process, a spacer layer and a protective layer that covers over an end of the pixel electrode; and
the forming the light emitting layer that covers over the pixel electrode further comprises: forming the light emitting layer on the pixel electrode such that the light emitting layer covers over the pixel electrode and the protective layer.
